Europäisches Patentamt

European Patent Office

Office européen des brevets

(19)

(11) Veröffentlichungsnummer: **0 164 083 B1**

# EUROPÄISCHE PATENTSCHRIFT

(12)

(45) Veröffentlichungstag der Patentschrift: 02.05.91

(21) Anmeldenummer: 85106774.4

(22) Anmeldetag: 01.06.85

(51) Int. Cl.⁵: **G03F 7/004**, G03F 7/16, G03F 7/022

(54) Positiv arbeitende strahlungsempfindliche Beschichtungslösung.

(30) Priorität: 07.06.84 DE 3421160
21.03.85 DE 3510220

(43) Veröffentlichungstag der Anmeldung:
11.12.85 Patentblatt 85/50

(45) Bekanntmachung des Hinweises auf die
Patenterteilung:
02.05.91 Patentblatt 91/18

(84) Benannte Vertragsstaaten:
AT BE CH DE FR GB IT LI NL SE

(56) Entgegenhaltungen:
EP-A- 0 042 104
EP-A- 0 078 981
EP-A- 0 153 682
EP-A- 0 164 248

CHEMICAL ABSTRACTS, Band 48, Nr. 22, 25.
November 1954, Spalte 13951f, Columbus,
Ohio, US; V.K. ROWE et al.: "Toxicology of
mono-, di-, and tri-propylene glycol methyl
ethers" & ARCH. IND. HYG. OCCUPATIONAL
MED. 9, 509-25(1954).

(73) Patentinhaber: HOECHST AKTIENGESELL-
SCHAFT
Postfach 80 03 20
W-6230 Frankfurt am Main 80(DE)

(72) Erfinder: Ruckert, Hans, Dr.
Erbsenacker 21
W-6200 Wiesbaden-Naurod(DE)
Erfinder: Ohlenmacher, Ralf
Wittelsbacher Strasse 33
W-6200 Wiesbaden(DE)

## Beschreibung

Die Erfindung betrifft eine positiv arbeitende strahlungsempfindliche Beschichtungslösung, die insbesondere zur Herstellung von Photoresistschichten geeignet ist.

Positiv arbeitende Photoresistlösungen auf Basis von Naphthochinondiaziden oder von säurespaltbaren Verbindungen in Kombination mit Verbindungen, die unter aktinischer Strahlung eine starke Säure bilden, sind bekannt. Sie werden verbreitet zur Herstellung von gedruckten Schaltungen, mikroelektronischen Bauelementen, zum Formteilätzen und dgl. eingesetzt.

Bei diesen Anwendungsgebieten ist es üblich, daß die lichtempfindlichen Beschichtungslösungen vom Hersteller geliefert und vom Anwender auf die jeweils zu beschichtenden Schichtträger, z. B. Siliciumwafer oder kupferkaschierte Isolierstoffplatten, aufgebracht und getrocknet werden. Naturgemäß ist die hier geübte Einzelbeschichtung schwieriger durchzuführen und störanfälliger als die fabrikmäßige Beschichtung von endlosen Schichtträgern im kontinuierlichen Durchgang, wie sie bei der Herstellung vorsensibilisierter Druckplatten oder von Trockenphotoresistfolien erfolgt. Bei der Einzelbeschichtung durch den Anwender ist es regelmäßig schwieriger, genau reproduzierbare Standardbedingungen bei der Beschichtung einzuhalten. Eine erhebliche Rolle spielt bei diesen Problemen der Praxis nicht nur die Art und der Mengenanteil der festen Schichtbestandteile, sondern auch die Art des zumeist organischen Lösemittels. Da viele Verbraucher, die nur in kleinem Umfang beschichten, keine Einrichtungen zur Rückgewinnung oder umweltfreundlichen Beseitigung der Lösemitteldämpfe haben, dürfen nur solche Lösemittel eingesetzt werden, die nicht gesundheitsschädlich sind. Da die Normen für die Zulässigkeit organischer Lösemittel am Arbeitsplatz in neuerer Zeit wesentlich strenger geworden sind, ist hierdurch die Wahl stark eingeschränkt worden. Andererseits soll die Lösung auch bei unterschiedlichen Temperaturen und Trockenbedingungen zu einer möglichst gleichmäßigen streifenfreien Schicht antrocknen. Dies hat man gewöhnlich dadurch zu erreichen versucht, daß man ein Lösemittelgemisch aus Komponenten mit unterschiedlichen Lösevermögen gegenüber den Schichtbestandteilen und mit unterschiedlichen Verdunstungszahlen verwendet hat, so daß im Laufe des Trocknungsvorgangs eine allmähliche Erstarrung der Schicht erfolgt, ohne daß es zu Inhomogenitäten durch vorzeitige Abscheidung einzelner Bestandteile kommt. Aus diesen Gründen enthalten die meisten in der Praxis eingesetzten handelsüblichen Photoresistlösungen ein Gemisch von mehreren Lösemitteln.

Als Lösemittel für Positiv-Photoresistlösungen auf Basis von 1,2-Chinondiaziden werden in der US-A 3 634 082 Ethylenglykolmonomethylether, Ethylenglykolmonoethylether, aliphatische Ester, z. B. Butylacetat, aliphatische Ketone, z. B. Methylisobutylketon und Aceton, Dioxan, Xylol, halogenierte aromatische Verbindungen, z. B. chloriertes Xylol, Benzol und Toluol genannt.

Im Prinzip die gleichen Lösemittel werden auch für positiv arbeitende Photoresistgemische auf Basis von säurespaltbaren Verbindungen verwendet, wie sie z. B. in der US-A 4 101 323 und der EP-A 42 562 beschrieben sind.

Hauptbestandteil der technischen Photoresistlösungen sind im allgemeinen Ethylenglykolderivate, wie die Monomethyl- und Monoethylether, die entsprechenden Ether des Diethylenglykols oder das Ethylenglykolethyletheracetat. Diese Lösemittel zeichnen sich durch ein gutes Lösevermögen für alle gebräuchlichen Schichtbestandteile, durch günstige Siedepunkte und Verdunstungszahlen und durch einen akzeptablen Preis aus. Sie ergeben jedoch nicht unter allen Bedingungen fehlerfreie Beschichtungen. Auch sind in neuerer Zeit die zulässigen Werte für ihre Konzentrationen in der Luft am Arbeitsplatz herabgesetzt worden.

Aufgabe der Erfindung war es deshalb, eine Photoresistlösung vorzuschlagen, deren Lösemittel im Hinblick auf Siedepunkt, Dampfdruck, Lösevermögen und Preis den bisher bevorzugten Lösemitteln entspricht, die jedoch zusätzlich eine bessere Beschichtungsqualität ergibt und weniger gesundheitsgefährdend ist.

In den prioritätsälteren, aber nicht vorveröffentlichten EP-A 0 164 248 und 0 153 682 werden als Lösemittel für strahlungsempfindliche Gemische Monoalkylether des 1,2-Propandiols genannt. Expressis verbis nennt die EP-A 0 164 248 den Monopropyl- und den Monobutylether des 1,2-Propandiols. Die EP-A 0 153 682 dagegen nennt den Monomethylether des 1,2-Propandiols; diesen allerdings nur im Zusammenhang mit einem strahlungsempfindlichen Gemisch, in dem als Bindemittel ein Copolymeres aus Isoeugenol und Maleinsäureanhydrid (RSV-Wert: 0,343 dl/g in Dimethylformamid) verwendet wird.

Erfindungsgemäß wird eine positiv arbeitende strahlungsempfindliche Beschichtungslösung vorgeschlagen, die als wesentliche Bestandteile eine strahlungsempfindliche Verbindung oder eine strahlungsempfindliche Kombination von Verbindungen, ein polymeres Bindemittel und ein organisches Lösemittel oder Lösemittelgemisch enthält, das mindestens zum überwiegenden Teil aus einem Glykolether besteht, dadurch gekennzeichnet, daß der Glykolether ein Mono-$C_1$ oder $C_2$-alkylether des 1,2-Propandiols ist und von den Bindemitteln ein Copolymeres an Isoeugenol und Maleinsäureanhydrid (RSV-Wert: 0,343 dl/g in Dimethylformamid) ausgeschlossen ist. Vorzugsweise ist der Glykolether ein Monomethylether des 1,2-Propandiols.

Die Alkylethergruppe kann in der 1-Stellung oder der 2-Stellung des Propandiols stehen, im allgemeinen wird beim Monomethylether das leichter zugängliche 1-Methoxypropan-2-ol bevorzugt. Es können auch Gemische von beiden Methylisomeren und/oder Gemische der Mono-$C_1$ oder $C_2$-alkylether des Propandiols eingesetzt werden.

Die genannten Lösemittel sind handelsüblich. Sie sind in der Arbeitsplatzatmosphäre in höheren Konzentrationen zugelassen als die bisher verwendeten Ethylenglykolether. Sie haben den weiteren Vorteil, daß sie in vielen Fällen einheitlicher verlaufende Beschichtungslösungen und gleichmäßigere Schichten ergeben als die entsprechenden Ether des Ethylenglykols, besonders dann, wenn diese Lösemittel als einzige Beschichtungslösemittel verwendet werden. Die Vorteile im Verhalten der Lösung bleiben erhalten, wenn ein Teil des Propandiolmonoalkylethers durch andere übliche Zusatzlösemittel, wie Ester, z. B. Butylacetat, Kohlenwasserstoffe, z. B. Xylol, Ketone, z. B. Aceton oder Butanon, Alkohole oder bestimmte Alkoxyalkylester, z.B. 3-Methoxy-butylacetat, ersetzt wird. Auf diese Weise ist es möglich, falls gewünscht, im Einzelfall das Benetzungs-, Fließ- und Verdunstungsverhalten der Lösung zu modifizieren. Der Mengenanteil an solchen zusätzlichen Lösemitteln sollte in jedem Fall unter 50 Gew.-% liegen. Bevorzugt beträgt der Anteil 0-35, insbesondere 0-20 Gew.-%, bezogen auf das Lösemittelgemisch. Dementsprechend besteht das erfindungsgemäße Lösemittel bzw. Lösemittelgemisch zu 65 bis 100 % aus einem 1,2-Propandiolmono-$C_1$ und/oder $C_2$-alkylether. Es ist z. B. auch möglich, durch Zusatz höhersiedender Alkohole oder Ether, die beim Trocknen in geringer Menge (z. B. 1-2 %) in der Schicht zurückbleiben, die Flexibilität der Schicht zu erhöhen. Ebenso kann gewünschtenfalls die Verdunstungsgeschwindigkeit durch Zusatz eines niedriger siedenden Lösemittels, z. B. sec.Butanol, erhöht werden.

Die Photoresistlösung kann in üblicher Weise, z. B. durch Tauchen, Gießen, Schleudern, Sprühen, mittels Walzen oder durch Schlitzdüsen auf den zu beschichtenden Träger aufgebracht werden.

In den meisten Fällen ist es vorteilhaft, außer dem Alkoxypropanol keine weiteren Lösemittel einzusetzen.

Der Gesamtfeststoffgehalt der erfindungsgemäßen Lösung liegt je nach Art der lichtempfindlichen Verbindungen und Bindemittel und nach Verwendungszweck im allgemeinen zwischen 10 und 50, vorzugsweise zwischen 15 und 35 Gew.-%.

Die erfindungsgemäßen Beschichtungslösungen enthalten ferner eine strahlungs- bzw. lichtempfindliche Verbindung oder eine strahlungs- bzw. lichtempfindliche Kombination von Verbindungen. Geeignet sind positiv arbeitende Verbindungen, d. h. solche, die durch Belichten löslich werden. Hierzu gehören 1,2-Chinondiazide und Kombinationen von photolytischen Säurespendern und säurespaltbaren Verbindungen, wie Orthocarbonsäure- und Acetalverbindungen.

1,2-Chinondiazide sind bekannt und z. B. in den DE-C 938 233 und 1 543 721, den DE-A 23 31 377, 25 47 905 und 28 28 037 beschrieben. Als 1,2-Chinondiazide werden bevorzugt 1,2-Naphthochinon-2-diazid-4- oder -5-sulfonsäureester oder -amide verwendet. Von diesen werden die Ester, insbesondere die der Sulfonsäuren, besonders bevorzugt. Die Menge an 1,2-Chinondiazidverbindungen beträgt im allgemeinen 3 bis 50, bevorzugt 7 bis 35 Gew.-%, bezogen auf die nichtflüchtigen Anteile des Gemischs.

Auch Beschichtungslösungen auf Basis säurespaltbarer Verbindungen sind bekannt und z. B. in den US-A 3 779 778 und 4 101 323, der DE-C 27 18 254 und den DE-A 28 29 512 und 28 29 511 beschrieben. Sie enthalten als säurespaltbare Verbindungen Orthocarbonsäurederivate, monomere oder polymere Acetale, Enolether oder Acyliminocarbonate. Als strahlungsempfindliche, Säure bildende Verbindungen enthalten sie vorwiegend organische Halogenverbindungen, insbesondere durch Halogenmethylgruppen substituierte s-Triazine oder 2-Trichlormethyl-1,3,4-oxadiazole.

Von den in der US-A 4 101 323 beschriebenen Orthocarbonsäurederivaten werden besonders die Bis-1,3-dioxan-2-yl-ether von aliphatischen Diolen verwendet. Von den in der DE-C 27 18 254 beschriebenen Polyacetalen werden diejenigen mit aliphatischen Aldehyd- und Dioleinheiten bevorzugt.

Weitere gut geeignete Gemische sind in der DE-A 29 28 636 beschrieben. Dort werden als säurespaltbare Verbindungen polymere Orthoester mit wiederkehrenden Orthoestergruppen in der Hauptkette beschrieben. Diese Gruppen sind 2-Alkylether von 1,3-Dioxa-cycloalkanen mit 5 oder 6 Ringgliedern. Besonders bevorzugt werden Polymere mit wiederkehrenden 1,3-Dioxa-cyclohex-2-yl-alkylethereinheiten, in denen die Alkylethergruppe durch Ethersauerstoffatome unterbrochen sein kann und bevorzugt an die 5-Stellung des benachbarten Rings gebunden ist.

Der Mengenanteil der säurespaltbaren Verbindungen in dem lichtempfindlichen Gemisch liegt im allgemeinen zwischen 8 und 65, vorzugsweise zwischen 14 und 44 Gew.-%, bezogen auf die nichtflüchtigen Bestandteile des Gemischs. Die Menge der Säure bildenden Verbindung liegt zwischen 0,1 und 10, vorzugsweise zwischen 0,2 und 5 Gew.-%.

3

Die erfindungsgemäßen Beschichtungslösungen können zusätzlich zu den vorstehend beschriebenen lichtempfindlichen Bestandteilen polymere Bindemittel enthalten. Dabei werden solche Polymeren bevorzugt, die wasserunlöslich und in wäßrig-alkalischen Lösungen löslich oder quellbar sind.

Als alkalilösliche bzw. in Alkali quellbare Bindemittel sind natürliche Harze wie Schellack und Kolophonium und synthetische Harze wie Mischpolymerisate aus Styrol und Maleinsäureanhydrid oder Mischpolymerisate der Acrylsäure oder Methacrylsäure, insbesondere mit Acryl- oder Methacrylsäureestern, sowie insbesondere Novolake zu nennen. Als Novolak-Kondensationsharze haben sich besonders die höher kondensierten Harze mit substituierten Phenolen als Formaldehyd-Kondensationspartner bewährt. Die Art und Menge der alkalilöslichen Harze kann je nach Anwendungszweck verschieden sein; bevorzugt sind Anteile am Gesamtfeststoff zwischen 30 und 90, besonders bevorzugt 55 - 85 Gew.-%. Statt oder im Gemisch mit Novolaken sind vorteilhaft auch Phenolharze vom Typ des Poly(4-vinylphenols) verwendbar. Zusätzlich können noch zahlreiche andere Harze mitverwendet werden, bevorzugt Vinylpolymerisate wie Polyvinylacetate, Polyacrylate, Polyvinylether und Polyvinylpyrrolidone, die selbst durch Comonomere modifiziert sein können. Der günstigste Anteil an diesen Harzen richtet sich nach den anwendungstechnischen Erfordernissen und dem Einfluß auf die Entwicklungsbedingungen und beträgt im allgemeinen nicht mehr als 20 % vom alkalilöslichen Harz. In geringen Mengen kann das lichtempfindliche Gemisch für spezielle Erfordernisse wie Flexibilität, Haftung und Glanz etc. außerdem noch Substanzen wie Polyglykole, Cellulosederivate wie Ethylcellulose, Netzmittel, Farbstoffe und feinteilige Pigmente sowie bei Bedarf UV-Absorber enthalten.

Als Träger, die mit den erfindungsgemäßen Lösungen beschichtet werden können, sind alle in der Photoresisttechnik gebräuchlichen Materialien geeignet, z. B. kupferkaschierte Isolierstoffplatten, Kupferzylinder für den Tiefdruck, Nickelzylinder für den Siebdruck, Aluminiumplatten, Glasplatten sowie die in der Mikroelektronik üblichen Silicium-, Siliciumnitrid- und Siliciumdioxidoberflächen. Auch Hoch- und Offsetdruckplatten können durch Aufbringen der erfindungsgemäßen Beschichtungslösungen, z. B. auf Zink-, Messing-Chrom- oder Aluminium-Kupfer-Chrom-, Aluminium- oder Stahlplatten, hergestellt werden.

Die beschichteten lichtempfindlichen Materialien werden mit üblichen Lichtquellen, deren Emissionsmaxima im nahen UV- oder kurzwelligen sichtbaren Licht liegen, belichtet. Die Bebilderung kann auch mit Elektronen-, Röntgen- oder Laserstrahlung erfolgen.

Die zum Entwickeln verwendeten wäßrig-alkalischen Lösungen abgestufter Alkalität, d. h. mit einem pH; das bevorzugt zwischen 10 und 14 liegt, und die auch kleinere Mengen organischer Lösungs- oder Netzmittel enthalten können, entfernen die vom Licht getroffenen Stellen der Kopierschicht und erzeugen so ein positives Abbild der Vorlage.

Die folgenden Beispiele beschreiben bevorzugte Ausführungsformen der Erfindung. Mengenverhältnisse und Prozentzahlen sind, wenn nichts anderes angegeben ist, in Gewichtseinheiten zu verstehen. Gewichtsteile (Gt) und Volumteile (Vt) stehen im Verhältnis von g zu cm$^3$.

Beispiel 1

In diesem Beispiel wird gezeigt, wie mit der folgenden Photoresistlösung galvanoplastisch Nickel-Rotationsschablonen für den Textildruck hergestellt werden können.
Eine Lösung aus

15     Gt Butanon,

45     Gt 1-Methoxy-propan-2-ol (Dowanol PM, Dow Chem. Co., USA),

28     Gt eines Kresol-Formaldehyd-Novolaks mit dem Erweichungsbereich 105-120°C nach DIN 53181,

3,5  Gt Polyvinylethylether (Lutonal A 25),

8,3  Gt des Polyacetals aus 2-Ethylbutyraldehyd und Triethylenglykol,

0,2  Gt 2-(6-Methoxy-naphth-2-yl)-4,6-bis-trichlor-methyl-s-triazin und

0,01 Gt Kristallviolettbase

wird hergestellt. Auf einen blanken, etwas kontrahierbaren Nickelzylinder, der mit einer leitenden Trennschichtversehen ist, wird durch 2-maliges Sprühbeschichten mittels Druckluft und mit Zwischentrocknung eine 60-75 $\mu$m dicke Schicht guter Oberflächenqualität aufgebracht. Der dabei rotierende Zylinder wird anschließend ca. 30 Minuten unter Infrarotstrahlern ausreichend getrocknet. Durch Herabsetzen des Butanongehalts kann die Verlaufzeit der Beschichtungslösung bis zum Trocknen und die Schichtdicke variiert werden. Auch bei völligem Fortlassen des Butanon wird eine Schicht mit guter Oberflächenqualität erhalten.

Wird stattdessen ein Gemisch aus 40 Gt Butanon, 15 Gt $\beta$-Ethoxy-ethylacetat und 5 Gt 2-($\beta$-Ethoxy-ethoxy)ethanol als Lösungsmittel für das oben angegebene Beschichtungsgemisch verwendet, so wird ebenfalls eine gute Beschichtungsqualität erhalten. Es ist aber nicht möglich, mit einem dieser Lösungsmittel allein unter Praxisbedingungen zu einer gleich guten Schichtqualität zu gelangen.

Der beschichtete Nickelzylinder wird dann unter einem Positiv des zu druckenden Motivs, dessen Tonwertabstufungen mit einem Raster von 32 Linien/cm in Bildpartien unterschiedlicher Flächendeckung umgesetzt worden sind, ausreichend belichtet. Für eine Positivschicht der halben Dicke auf Basis von 1,2-Naphthochinondiazid ist die 4-fache Belichtungszeit nötig. Entwickelt wird mit einer Lösung von

0,5 % NaOH,

0,8 % Natriummetasilikat x 9 Wasser,

1,0 % Ethylenglykolmono-n-butylether in

97,7 % vollentsalztem Wasser.

Dazu wird der rotierende belichtete Zylinder in eine mit dem Entwickler halbgefüllte Wanne entsprechender Größe eingetaucht. Die Entwicklerresistenz der Schicht ist sehr gut und ermöglicht steile Flanken der Resistkanten. Nach 6 Minuten Rotieren des Zylinders im Entwickler wird die Entwicklerwanne weggezogen und der Zylinder mit Wasser gespült und an der Luft getrocknet.

Auf den freigelegten Stellen des Zylinderkerns wird galvanisch Nickel bis zu einer Dicke von 0,1 mm abgeschieden. Nach Kontrahieren des Zylinderkerns, Ablösen der Resistschablone mit Aceton und Abziehen vom Kern wird eine elastische Rotations-Schablonendruckform erhalten. Durch die Löcher der Rotationsschablone wird Farbe bildmäßig auf Bedruckstoffe übertragen.

Ähnliche Ergebnisse werden erhalten, wenn als spaltbare Verbindung das Polyacetal aus n-Heptanal und Tetraethylenglykol verwendet wird.

Beispiel 2

Dieses Beispiel zeigt die Beschichtung mit der erfindungsgemäßen Beschichtungslösung im Walzenantrag (roller-coater) bei der Herstellung von Feinleiterplatten.

Die folgenden Schichtbestandteile:

64 Gt Novolak wie in Beispiel 1,

11 Gt Polyvinylmethylether (Lutonal M 40),

15 Gt Polyacetal aus 2-Ethylbutyraldehyd und
     Hexan-1,6-diol,

9,5 Gt des Polyorthoesters aus Trimethoxymethan und
     5-Oxa-7,7-di-hydroxymethyl-nonan-1-ol,

0,4 Gt 2-Acenaphth-5-yl-4,6-bis-trichlormethyl-
     s-triazin und

0,1 Gt Kristallviolettbase

werden in 1-Methoxy-propan-2-ol zu einer Lösung von 30 % Feststoffgehalt gelöst. Man erhält eine Beschichtungslösung einer Viskosität von etwa 90 mm²/s. Eine entsprechende Lösung von 40 % Feststoffgehalt hat eine Viskosität von ungefähr 200 mm²/s. Wird statt 1-Methoxy-propanol-2 das 1-Ethoxy-propanol-2 (Ethoxypropanol EP, Deutsche BP-Chemie GmbH) eingesetzt, so erhält man eine Viskosität der 40 %igen Beschichtungslösung von ca. 320 mm²/s.

Beim Aufbringen einer solchen Lösung auf durchkontaktierte kupferkaschierte Isolierstoffplatten durch Walzenantrag, z. B. einem handelsüblichen Walzenantragsgerät (roller-coater) der Firma Bürkle, Freudenstadt, Bundesrepublik Deutschland, zur doppelseitigen Beschichtung, Typ AKL 400, das mit Gummi-Riffelwalzen mit 48 oder 64 Rillen je 2,5 cm (linear) ausgestattet ist, kann man je nach Resistlösung, Riffelwalze und Maschineneinstellung durch einmaligen Antrag Trockenschichtdicken von etwa 3 bis 14 μm erhalten. Verlauf und Trockenzeit können je nach gewünschten Taktzeiten des Prozesses auch durch Wahl von 1-Methoxy- oder 1-Ethoxy-propanol-2 bzw. deren Mischungen eingestellt werden.

Mit der beschriebenen Beschichtungslösung werden ähnlich gute Verlauf- und Trockeneigenschaften erzielt wie mit einem sonst gleichen Feststoffgemisch, das in einer üblichen Mischung aus β-Ethoxyethylacetat, Xylol und Butylacetat, ggf. unter Zusatz eines o,p-Chlortoluol-Gemischs, gelöst ist.

Nach dem Trocknen wird die Platte zunächst unter einer negativen Vorlage, die den Lochbereichen entspricht, belichtet, dann werden mit dem in Beispiel 1 angegebenen Entwickler diese Bereiche ausgewaschen, die Platte wird 10 Minuten bei 80°C getrocknet, dann an den freigelegten Lochbereichen galvanisch mit Kupfer verstärkt und galvanisch verzinnt. Danach wird die Photoresistschicht unter einer positiven Leiterbahn-Vorlage belichtet und wie oben entwickelt. Das freigelegte Kupfer wird mit einem alkalischen Ätzmittel weggeätzt.

Wenn für die erhaltene Photoresistschicht in bestimmten Fällen eine weichere Konsistenz und höhere Flexibilität gewünscht wird, wird anstelle des oben angegebenen reinen Lösemittels ein Gemisch aus 85 % 1-Methoxy-propan-2-ol und 15 % 2-Ethyl-butanol verwendet. Von dem höher siedenden Lösemittel verbleibt nach dem Trocknen ein kleiner Rest (bis zu etwa 2 %) in der Schicht und wirkt als Weichmacher. Ähnliche Ergebnisse werden durch Zumischen von 10 % 3-Methoxy-butanol oder von 20 % 3-Methoxy-butylacetat erhalten. Außerdem kann als Zusatz das 1-Isobutoxy-propanol-2 (iBP der deutschen BP-Chemie) verwendet werden.

Beispiel 3

Eine Lösung von

```
12    Gt Novolak wie in Beispiel 1,
10    Gt einer 50 %igen Lösung von Polyvinylmethyl-
      ether in Toluol und
 4    Gt 1,2-Naphthochinon-2-diazid-4-sulfonsäure-
      ester des 4-(2-Phenyl-prop-2-yl)phenols in
74    Gt eines Gemischs aus gleichen Teilen 1-Methoxy-
      propan-2-ol und 2-Methoxy-propan-1-ol
      (Dowanol PM und Solvenon PM, BASF AG).
```

wird auf eine mit Indium-Zinn-Oxid beschichtete Glasscheibe für die Herstellung von Flüssigkristall-Anzeigeelementen (LCD-Displays) in einer elektrostatischen Sprühvorrichtung wie folgt aufgebracht:

Die Lösung wird mittels einer Hochrotationsglocke mit einem Durchmesser von 60 mm bei 40000 Umdrehungen je Minute und 100 kV Gleichspannung und mittels einer Pumpe in definierter Menge versprüht. Die Glocke hat einen Abstand von 30 cm von dem Beschichtungstisch, über den die geerdete Glasplatte geführt wird. Der Stromfluß beträgt unter den angegebenen Bedingungen weniger als 1 mA. Durch Verändern des Vorschubs zwischen 0,8 und 2 m je Minute und der Pumpendrehzahl konnten Schichtdicken - trocken gemessen - im Bereich von etwa 4 bis 10 μm eingestellt werden. Wenn man Schichtdicken um 5 μm erhalten will, ist es zweckmäßiger, die Konzentration der Lösung, ggf. mit einem höhersiedenden Lösemittel, auf 15 % einzustellen.

Nach dem Trocknen wird unter einer Positivvorlage belichtet, die die Zuleitungen zu den Anzeigefeldern eines Drehzahlmessers darstellt, dann mit der in Beispiel 1 angegebenen Lösung entwickelt und das Indium-Zinn-Oxid an den freigelegten Stellen durch Ätzen mit 5%iger Salzsäure entfernt.

Beispiel 4

Die folgende Positiv-Photoresistlösung wird wie in Beispiel 1 zum Aufbringen feiner Schaltungsmuster auf Silicium-Wafer verwendet.

```
76     Gt 1-Methoxy-propan-2-ol,
13,6   Gt Novolak wie in Beispiel 1,
 6,6   Gt 1,3-Bis-[2-(5-ethyl-5-butyl-1,3-dioxa-
       cyclohexoxy)]-2-ethyl-2-butyl-propan,
 1,1   Gt des in Beispiel 2 angegebenen Triazins,
 2,7   Gt Polyvinylethylether (Lutonal A 25).
```

Nach Aufschleudern dieser Lösung mit 6000 U/min und Nachtrocknen im Umlufttrockenschrank wird ein lagerfähiger, positiv vorsensibilisierter Wafer von mehrfach höherer Lichtempfindlichkeit, verglichen mit handelsüblichen Positiv-Photoresistschichten gleicher Dicke auf o-Naphthochinondiazid-Basis, erhalten. Beim Vergleich mit dem für die Mikroelektronik viel verwendeten handelsüblichen Photoresist AZ 1350 J auf Basis von o-Chinondiaziden werden beim Kopieren wie in Beispiel 1, jedoch unter Zwischenschaltung eines die Belichtungszeiten verlängernden Filters, für die Nichtdiazo-Schicht 3 Sekunden gebraucht, für die Diazo-Schicht 20 Sekunden. Beide Belichtungszeiten sind jeweils optimiert auf gute Auflösung bis ca. Feld 3/2 der ITEK-Testvorlage bei 1 Minute Entwicklung in der in Beispiel 1 angegebenen Entwicklerlösung. Wie bei AZ 1350 J ist es möglich, eventuell auftretende Schleuderstrukturen durch Zugabe eines Polysiloxan- oder Fluortensids, wie sie in den EP-A 42 104 und 42 105 beschrieben sind, zu vermeiden. Eine ähnliche Beschichtungsqualität erhält man, wenn man statt 1-Methoxy-propanol-2 das 1-Ethoxy-propanol-2 verwendet.

Beispiel 5

Zur Herstellung von Positiv-Photoresistlösungen für die Herstellung von autotypischen Kupfer-Tiefdruck-zylindern werden

| 12 | Gt Novolak wie in Beispiel 1, |
|---|---|
| 1 | Gt eines Mischpolymerisats aus 95 % Vinyl-acetat und 5 % Crotonsäure, |
| 2 | Gt eines Estergemischs aus 1 mol 2,3,4-Trihydroxy-benzophenon und 2 mol 1,2- |

Naphthochinon-2-diazid-5-sulfonsäurechlorid
und

| 0,1 | Gt Kristallviolettbase in |
|---|---|
| 85 | Gt 1-Methoxy-propan-2-ol |

unter Rühren gelöst.
Mit dieser Lösung und einer Vergleichslösung aus

| 24 | Gt Novolak wie oben, |
|---|---|
| . 2 | Gt Mischpolymerisat wie oben, |
| 4 | Gt Estergemisch wie oben und |
| 0,2 | Gt Kristallviolettbase in |
| 49 | Gt Trichlorethan, |
| 14 | Gt Isopropanol, |
| 7 | Gt Butylacetat und |
| 100 | Gt 2-Ethoxy-ethanol |

wird mittels einer Spritzpistole je die Hälfte eines frisch verkupferten rotierenden Kupferzylinders ca. 4 μm dick beschichtet und mittels Warmluft oder Infrarot-Strahlern getrocknet. Eine Untersuchung der beiden beschichteten Hälften ergibt, daß die mit der erfindungsgemäßen Lösung hergestellte Schicht wesentlich glatter und gleichmäßiger ist und einen schöneren Verlauf hat. Anschließend wird unter einem gerasterten Negativ des zu druckenden Motivs belichtet und durch Aufgießen von 0,8 %iger Natronlauge auf den langsam rotierenden Zylinder die Kupferoberfläche bildmäßig freigelegt, was bei diesen Schichten innerhalb 2 - 4 Minuten abgeschlossen ist.

Anschließend wird mit Wasser abgespült und durch weiteres Rotieren in warmer Luft der Zylinder getrocknet.

Vor der üblichen Tiefdruckätzung mit Ferrichlorid-Lösung werden an den zu vergleichenden zwei Schichtpartien Retuschen angebracht, indem mechanisch mittels eines Stichels korrigiert, Markierungen und zusätzliche Linien angebracht werden. Dies gelingt mit beiden Schichten etwa gleich gut, da die Schichten nach dem Trocknen noch etwa 1 % Restlöser enthalten, der bei der Vergleichsschicht im wesentlichen aus dem giftigen 2-Ethoxy-ethanol besteht.

Beispiel 6

In diesem Beispiel wird die Verwendung einer erfindungsgemäßen Beschichtungslösung für die Herstellung einer Offset-Druckform gezeigt.

Auf einseitig drahtgebürstetes Aluminium wird eine Beschichtungslösung aus

```
7     Gt Novolak wie in Beispiel 1,
2     Gt 2-(Naphth-2-yloxy)-5,5-dimethyl-1,3-oxazolin-
      4-on,
0,4   Gt 2-(4-Methoxy-anthrac-1-yl)-4,6-bis-trichlor-
      methyl-s-triazin und
0,1   Gt 4-Diethylamino-azobenzol in
90,8  Gt 1-Methoxy-propan-2-ol
```

mittels Walzenantrag aufgebracht. Die Oberfläche wird gut und gleichmäßig benetzt, und die Schicht bleibt bis zum Ende des Trockenvorgangs homogen. Wenn die Trocknung beschleunigt werden soll, kann das Lösemittel zu 15 % durch sec.-Butanol ersetzt werden. Wenn der Trocknungsvorgang verlangsamt werden soll, kann das 1-Methoxy-propanol-2 ganz oder teilweise durch 1-Ethoxy-propanol-2 ersetzt werden.

Die Dicke der erhaltenen Schicht entspricht einem Schichtgewicht von 2 g/m$^2$.

Nach dem Trocknen wird unter einer positiven Vorlage belichtet, mit einer 3,5 %igen wäßrigen Lösung von Trinatriumphosphat entwickelt, die durch Zugabe von Natriumhydroxid auf ein pH von 12,6 eingestellt ist, dann mit Wasser abgespült und schließlich durch Überwischen mit 1 %iger Phosphorsäure druckfertig gemacht. Selbst wenn man die Platte bis zum 12-fachen der ausreichenden Entwicklungszeit in der Entwicklerlösung liegen läßt, entstanden praktisch keine Schäden an den Bildstellen. Anschließend wird eine solche Platte zum Drucken verwendet und zeigt sehr schnelle Annahme der Druckfarbe.

Beispiel 7

Mit der Feststoffrezeptur von Beispiel 1, 40 %ig gelöst in 1-Ethoxypropanol-2, wurde ein sprühfähiges System für elektrostatische Sprühbeschichtung, ähnlich den Bedingungen von Beispiel 3 (Glockenabstand, 20 cm, Hochspannung 80 kV), eingestellt. Die Lösung wurde zunächst auf ca. 26 Gewichtsprozent Feststoff eingestellt durch Verdünnen mit 3-Methoxybutanol-1. Nach Trocknen ergab sich ein Schichtgewicht von ca. 5 g/m$^2$. Auf Schichtträgern, wie Aluminium- oder Kupferplatten, ergab sich ein guter Verlauf.

Bemerkenswert ist der sprühbare hohe Feststoffgehalt mit diesem Lacksystem. Es ergab sich, daß man auch bis zu ca. 5 % an Isobutoxy-propanol mitverwenden konnte, ohne daß die Sprühbedingungen geändert werden mußten.

**Ansprüche**

1. Positiv arbeitende strahlungsempfindliche Beschichtungslösung, die als wesentliche Bestandteile eine strahlungsempfindliche Verbindung oder eine strahlungsempfindliche Kombination von Verbindungen, ein polymeres Bindemittel und ein organisches Lösemittel oder Lösemittelgemisch enthält, das mindestens zum überwiegenden Teil aus einem Glykolether besteht, dadurch gekennzeichnet, daß der Glykolether ein Mono-C$_1$ oder C$_2$-alkylether des 1,2-Propandiols ist und von den Bindemitteln ein Copolymeres aus Isoeugenol und Maleinsäureanhydrid (RSV-Wert: 0,343 dl/g in Dimethylformamid) ausgeschlossen ist.

2. Strahlungsempfindliche Beschichtungslösung nach Anspruch 1, dadurch gekennzeichnet, daß der Glykolether ein Monomethylether des 1,2-Propandiols ist.

3. Strahlungsempfindliche Beschichtungslösung nach Ansprüchen 1 bis 2, dadurch gekennzeichnet, daß das polymere Bindemittel wasserunlöslich und in wäßrig-alkalischen Lösungen löslich ist.

**4.** Strahlungsempfindliche Beschichtungslösung nach Ansprüchen 1 bis 3, dadurch gekennzeichnet, daß sie als lichtempfindliche Verbindung ein 1,2-Naphthochinon-2-diazid enthält.

**5.** Strahlungsempfindliche Beschichtungslösung nach Ansprüchen 1 bis 3, dadurch gekennzeichnet, daß sie als strahlungsempfindliche Kombination von Verbindungen
a) eine Verbindung mit mindestens einer durch Säure spaltbaren C-O-C-Bindung und
b) eine bei Bestrahlung eine starke Säure bildende Verbindung
enthält.

**6.** Strahlungsempfindliche Beschichtungslösung nach Anspruch 3, dadurch gekennzeichnet, daß das polymere Bindemittel ein Novolak ist.

**7.** Strahlungsempfindliche Beschichtungslösung nach Ansprüchen 1 bis 3, dadurch gekennzeichnet, daß das Lösemittel bzw. Lösemittelgemisch zu 65 bis 100 % aus einem 1,2-Propandiolmono-$C_1$ oder $C_2$-alkylether besteht.

## Claims

**1.** Positive-working radiation-sensitive coating solution which contains, as the essential constituents, a radiation-sensitive compound or a radiation-sensitive combination of compounds, a polymeric binder and an organic solvent or solvent mixture which, at least for the most part, consists of a glycol ether, characterized in that the glycol ether is a mono-$C_1$- or $C_2$-alkyl ether of 1,2-propanediol, and in that from among the binders a copolymer of iso-eugenol and maleic anhydride (RSV value: 0.343 dl/g, in dimethylformamide) is excluded.

**2.** Radiation-sensitive coating solution as claimed in Claim 1, characterized in that the glycol ether is a monomethyl ether of 1,2-propanediol.

**3.** Radiation-sensitive coating solution as claimed in Claims 1 and 2, characterized in that the polymeric binder is insoluble in water and soluble in aqueous-alkaline solutions.

**4.** Radiation-sensitive coating solution as claimed in Claims 1 to 3, characterized in that the 1,2-naphthoquinone-2-diazide is contained therein as the photosensitive compound.

**5.** Radiation-sensitive coating solution as claimed in Claims 1 to 3, characterized in that
a) a compound possessing at least one C-O-C bond which can be split by acid and
b) a compound which upon radiation forms a strong acid are contained therein as a radiation-sensitive combination of compounds.

**6.** Radiation-sensitive coating solution as claimed in Claim 3, characterized in that the polymeric binder is a novolak.

**7.** Radiation-sensitive coating solution as claimed in Claims 1 to 3, characterized in that 65 to 100 % of the solvent or solvent mixture, respectively, are constituted by a 1,2-propanediol mono-$C_1$ or $C_2$-alkyl ether.

## Revendications

**1.** Solution de revêtement sensible aux radiations, travaillant en positif, qui contient en tant que composants essentiels un composé sensible aux radiations ou une combinaison de composés sensible aux radiations, un liant polymère et un solvant ou mélange de solvants organiques qui consiste au moins pour la majeure partie en un éther de glycol, caractérisée en ce que l'éther de glycol est un éther monoalkylique en $C_1$ ou $C_2$ du 1,2-propanediol, et, parmi les liants, est exclu un copolymère d'iso-eugénol et d'anhydride maléique (valeur RSV: 0,343 dl/g dans du diméthylformamide).

**2.** Solution de revêtement sensible aux radiations selon la revendication 1, caractérisée en ce que l'éther de glycol est un éther monométhylique du 1,2-propanediol.

3. Solution de revêtement sensible aux radiations selon les revendications 1 et 2, caractérisée en ce que le liant polymère est insoluble dans l'eau et soluble dans des solutions aqueuses-alcalines.

4. Solution de revêtement sensible aux radiations selon les revendications 1 à 3, caractérisée en ce qu'elle contient, en tant que composé photosensible, un 1,2-naphtoquinone-2-diazide.

5. Solution de revêtement sensible aux radiations selon les revendications 1 à 3, caractérisée en ce qu'elle contient, en tant que combinaison de composés sensible aux radiations
   a) un composé comportant au moins une liaison C-O-C pouvant être rompue par un acide et
   b) un composé formant un acide fort lors d'irradiation.

6. Solution de revêtement sensible aux radiations selon la revendication 3, caractérisée en ce que le liant polymère est une Novolaque.

7. Solution de revêtement sensible aux radiations selon les revendications 1 à 3, caractérisée en ce que le solvant ou mélange de solvants est constitué, à raison de 65 à 100 %, d'un éther monoalkylique en $C_1$ ou $C_2$ de 1,2-propanediol.